# EUROPÄISCHE PATENTSCHRIFT

(11) **EP 2 553 589 B1**
(45) Veröffentlichungstag und Bekanntmachung des Hinweises auf die Patenterteilung: **05.11.2014**
(21) Anmeldenummer: 11709918.4
(22) Anmeldetag: 16.03.2011
(51) Int. Cl.: G06F 13/42, H04L 12/413

(54) **VERFAHREN ZUM ANSTEUERN EINER ANZAHL AN MODULEN**
METHOD FOR ACTUATING A NUMBER OF MODULES
PROCÉDÉ POUR ACTIONNER UN CERTAIN NOMBRE DE MODULES

(30) Priorität: 31.03.2010 DE 102010003558
(43) Veröffentlichungstag der Anmeldung: 06.02.2013
(73) Patentinhaber: Robert Bosch GmbH, 70442 Stuttgart (DE)
(72) Erfinder: SCHMITT, Stephen, 72622 Nuertingen (DE); WAGNER, Thomas, 72762 Reutlingen (DE); HANISCH, Juergen, 72658 Bempflingen (DE)
(86) Internationale Anmeldenummer: PCT/EP2011/053973
(87) Internationale Veröffentlichungsnummer: WO 2011/120806

(56) Entgegenhaltungen:
- DE-A1-102008 000 561
- HARTWICH F ET AL: "CAN Network with Time Triggered Communication", INTERNET CITATION, 16. Juni 2001 (2001-06-16), XP002242379, Gefunden im Internet: URL:http://web.archive.org/web/20010615082 442/http://www.can.bosch.com/do cu/CiA2000Paper_2.pdf [gefunden am 2003-05-23]

## Beschreibung

Die Erfindung betrifft ein Verfahren zum Ansteuern einer Anzahl an Modulen, insbesondere einer Anzahl an Hardwaremodulen bzw. -einheiten, und eine Schaltungsanordnung zur Durchführung des Verfahrens.

### Stand der Technik

Mikrocontroller, die in unterschiedlichen eingebetteten Systemen zum Einsatz kommen, kontrollieren u.a. Aktuatoren und Sensoren. Aktuatoren zeichnen sich dadurch aus, dass sie zu bestimmten Zeitpunkten mit Signalen versorgt und in vielen Fällen auch gleichzeitig angesteuert werden müssen, um eine Funktion zu erfüllen. Solche Ausgabesignale werden typischerweise mit hochkomplexen Zeitgeber- bzw. Timerarchitekturen angesteuert. Hierbei können mehrere Ausgabesignale aufgrund von vorgegebenen Zeitstempeln, Zählerwerten oder durch Triggerung der Zellen untereinander ausgegeben werden.

Bei bekannten Ansätzen hat sich als nachteilig herausgestellt, dass sich nur benachbarte Zellen in aufsteigender Reihenfolge oder Ketten von Zellen in aufsteigender Reihenfolge, die nicht unterbrochen werden dürfen, gegenseitig triggern können. Wird die Triggerung aufgrund eines Zeitwerts durchgeführt, haben bisherige Architekturen den Nachteil, dass sie die entsprechenden Zeitwerte zur Erzeugung neuer Signale per CPU nachladen müssen, was eine hohe Interruptlast auf der Haupt-CPU bedingt. XP002242379 offenbart ein Verfahren gemäß dem Oberbegriff des Anspruchs 1.

### Offenbarung der Erfindung

Vor diesem Hintergrund werden ein Verfahren nach Anspruch 1 und eine Schaltungsanordnung mit den Merkmalen des Anspruchs 6 vorgestellt. Ausgestaltungen ergeben sich aus den abhängigen Ansprüchen, der Beschreibung und den Zeichnungen.

Das vorgeschlagene Verfahren stellt einen flexiblen Triggermechanismus zur Verfügung, der nicht nur auf Zeitbasen arbeitet, sondern auch die Triggerung und Kontrolle mehrerer Hardwareeinheiten zur Signalausgabe gleichzeitig erlaubt. Der vorgeschlagene Triggermechanismus ist dabei so flexibel, dass sich auch nicht benachbarte Module gegenseitig benachrichtigen, einschalten, ausschalten oder das Nachladen von Parametersätzen antriggern können.

Die vorgeschlagene Schaltungsanordnung besteht aus einem Modul, das den flexiblen Triggermechanismus implementiert. Dort können die einzelnen angeschlossenen Module miteinander verschaltet werden und es können verschiedene Triggermechanismen (Zeit, CPU-Zugriff, andere(s) Ausgabemodul(e)...) eingestellt werden. Aufgrund der jeweiligen Triggerquelle ist es möglich, die Ausgabeeinheiten aus-, einzuschalten, und/oder die jeweiligen Ausgänge aus- oder einzuschalten und/oder einen Parametersatz parallel nachzuladen.

Die vorgestellte Lösung zeichnet sich dadurch aus, dass während der Laufzeit der Triggermechanismus umprogrammiert werden kann. Bei bekannten Ansätzen ist dies hingegen starr in den eingesetzten Multiplexern vorgegeben. Über den bereitgestellten internen Trigger kann jeder Kanal jeden anderen Kanal beeinflussen (Rückführung).

Der vorgeschlagene Triggermechanismus kann Bestandteil einer Timer-Plattform für den Automobilbereich sein. Alternativ kann der Mechanismus aber auch im industriellen Umfeld eingesetzt werden.

In einer Ausgestaltung ist eine Schaltungsanordnung für einen flexiblen Triggermechanismus für mindestens zwei Module bereitgestellt, bei der diese mindestens zwei Module zur gemeinsamen Triggerung keine topologische Besonderheit aufweisen müssen und die gemeinsame Triggerung nicht aufgrund einer globalen Zeitbasis erfolgen muss. Der beschriebene Triggermechanismus kann durch ein Zeitereignis, einen CPU-Trigger oder ein Triggerereignis einer oder mehrerer angeschlossenen Hardwareeinheit(en) ausgelöst werden. Weiterhin können die Ausgangstriggermechanismen parallel zueinander verwendet werden, wobei die Ausgangstriggermechanismen sowohl durch Hardware als auch durch Software ausgelöst werden können.

Zur Erzeugung einer Zeitbasis bzw. von Zeitbasen kann eine Zeitbasiseinheit (TBU; Time Base Unit) eingesetzt werden, die eine gemeinsame Zeitbasis für den Mikrocontroller bereitstellen kann. Die Zeitbasiseinheit bzw. das Zeitbasissubmodul ist in Kanälen organisiert, wobei die Anzahl an Kanälen geräteunabhängig ist. Es sind zumindest zwei Kanäle innerhalb der TBU implementiert. Typischerweise hat jeder der Kanäle ein Zeitbasisregister mit einer Länge von 24 Bit. Es können aber auch andere Längen, wie bspw. 16 Bit, 32 Bit usw., vorgesehen sein. Die Zeitbasiskanäle können unabhängig voneinander betrieben werden.

Weitere Vorteile und Ausgestaltungen der Erfindung ergeben sich aus der Beschreibung und den beiliegenden Zeichnungen.

Es versteht sich, dass die voranstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

### Kurze Beschreibung der Zeichnungen

- Figur 1: zeigt in einem Blockschaltbild eine Ausführungsform der vorgestellten Schaltungsanordnung.
- Figur 2: zeigt in einem Blockschaltbild die Anbindung von Hardwaremodulen an einen zentralen Triggermechanismus.

### Ausführungsformen der Erfindung

Die Erfindung ist anhand von Ausführungsformen in den Zeichnungen schematisch dargestellt und wird nachfolgend unter Bezugnahme auf die Zeichnungen ausführlich beschrieben.

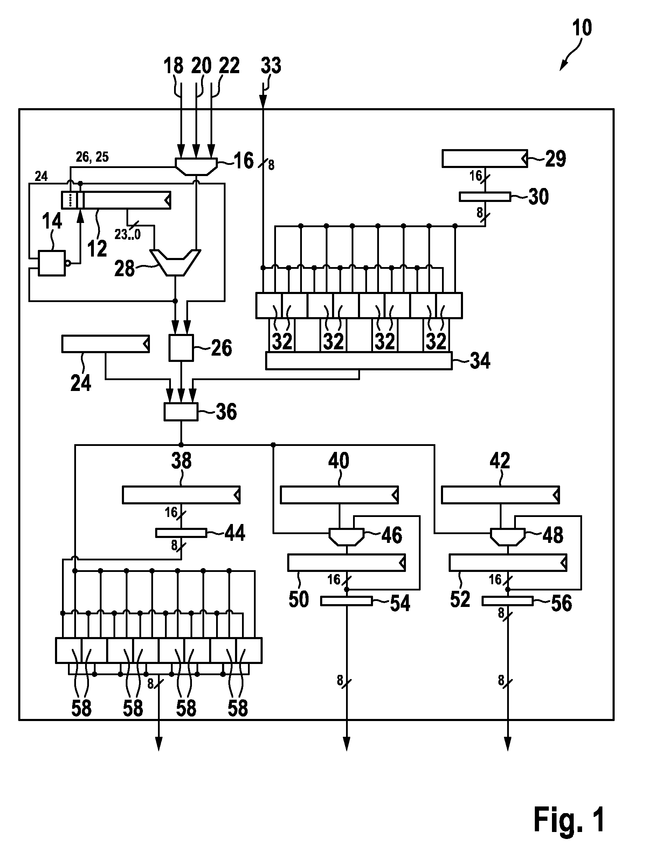

In Figur 1 ist in einem Blockschaltbild eine Schaltungsanordnung 10 dargestellt, die einen zentralen Triggermechanismus implementiert. Die Darstellung zeigt ein Register 12, in dem ein Sollwert_ACT_TB abgelegt ist, ein erstes UND-Gatter 14, einen Multiplexer 16 zur Eingabe von Zeitbasen TBU_TS2 18, TBU_TS1 20 und TBU_TS0 22, ein Register 24 zur Aufnahme eines externen Triggers Host_Trig, der über eine Busschnittstelle eingegeben wird, ein zweites UND-Glied 26, einen Komparator (=<) 28, ein weiteres Register 29 für eine Maske eines Hardwaretriggers, einen optionalen Encoder 30, acht weitere UND-Gatter 32, eine Schnittstelle 33 zur Eingabe von Signalen von externen Hardwareeinheiten, ein weiteres Oder-Gatter (>=1) 34, noch ein Oder-Gatter (>=1) 36, das das Signal CTRL_TRIG, das Triggersignal, ausgibt, ein weiteres Register 38 für den Wert FUPD_CTRL, ein Register 40 für den Wert OUTEN_CTRL, ein weiteres Register 42 für den Wert ENDIS_CTRL, einen weiteren optionalen Encoder 44, einen weiteren Multiplexer 46, noch einen weiteren Multiplexer 48, ein Register 50 für den Wert OUTEN_STAT, noch ein Register 52 für den Wert ENDIS_STAT, einen optionalen Encoder 54, der ein Signal OUTEN ausgibt, noch ein optionalen Encoder 56, der ein Signal ENDIS ausgibt und acht UND-Gatter 58, an deren Ausgang ein Signal FUPD ausgegeben wird.

Der Sollwert ACT_TB wird mit einem Eingabesignal, das durch die Zeitbasen 18 oder 20 oder 22 gegeben ist, verglichen, auf Grundlage des Vergleichs wird ein Trigger ausgelöst.

In Figur 1 ist ein zentraler Triggermechanismus dargestellt, der als Eingabesignale eine oder mehrere Zeitbasen und/oder Triggersignale von anderen Modulen vorsieht und/oder eine Busschnittstelle zur Konfiguration durch eine zentrale Recheneinheit bzw. CPU enthält. Die dort einlaufenden Signale können durch die vorgeschlagene Architektur flexibel miteinander verbunden werden und entsprechende Aktionen an den Ausgängen ausführen.

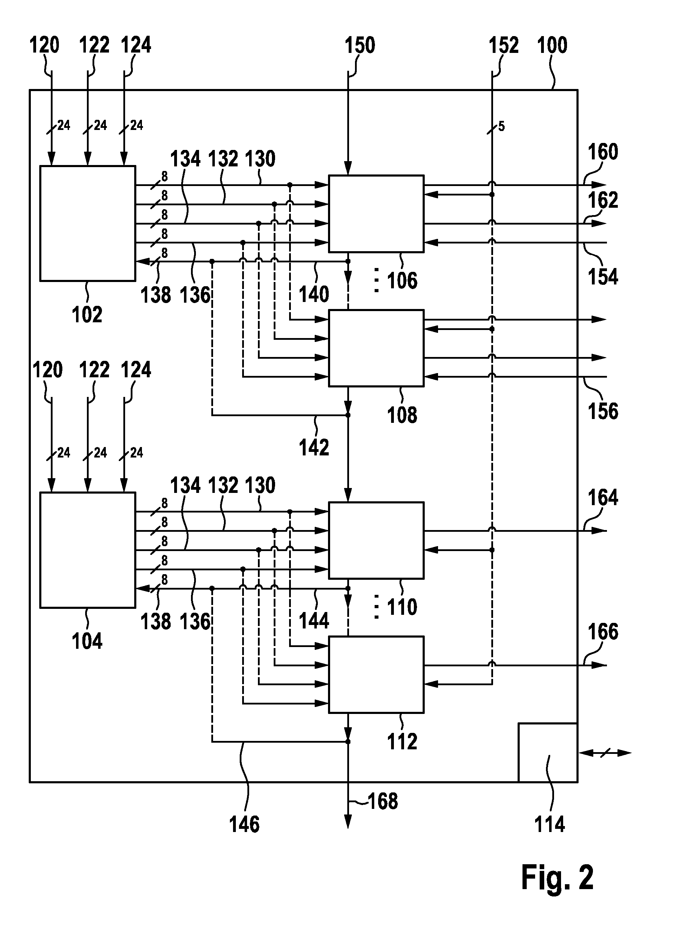

In Figur 2 ist ein Hardwaremodul TOM 100 dargestellt, das in diesem Fall als Zeitgeberausgabemodul vorgesehen ist und an einen zentralen Triggermechanismus angebunden ist.

Die Darstellung zeigt einen ersten Triggerkanal TGC0 102 und einen zweiten Triggerkanal TGC1 104. Der Triggerkanal TGC0 102 ist an acht Modulkanäle TOM_CH0 106 bis TOM_CH7 108 angeschlossen. Der Triggerkanal TGC1 104 ist an acht Modulkanäle TOM_CH8 110 bis TOM_CH15 112 angebunden. Weiterhin ist eine Schnittstelle 114 für einen Mikrocontroller-Bus vorgesehen.

In die beiden Triggerkanäle 102 und 104 werden als Eingabesignale Werte von Zeitbasen TBU_TS0 120, TBU_TS1 122 und TBU_TS2 124 eingegeben. Ausgaben der beiden Triggerkanäle 102 und 104 sind die Signale OUTEN 130, ENDIS 132, FUPD 134 und UPEN 136. Weiterhin ist ein Triggersignal TRIG 138 vorgesehen. Dieses Triggersignal 138 ist aufzuteilen in TRIG_0 140 bis TRIG_7 142, TRIG_8 144 bis TRIG_15 146.

Weitere Eingangssignale sind TOM_TRIG_[i-1] 150, CMU_FXCLK 152, SPE0_OUT 154 und SPE7_OUT 156 (SPE: Sensor Pattern Evaluation). Dabei ist die SPE ein Modul, das die Eingaben von Sensoren, bspw. von Hall-Sensoren, evaluiert. Ausgangssignale sind TOM_CH0 160, TOM_CH0_SOUR 162, TOM_CH8_OUT 164, TOM_CH15_OUT 166 und TOM_TRIG_[i] 168.

In Figur 1 ist dargestellt, wie die zu kontrollierenden Hardwaremodule mit dem flexiblen Triggermechanismus verschaltet sind. Ein Teil der Struktur ist dafür zuständig, Werte von Zeitbasen (TBU_TSx) aufzunehmen und mit einem Sollwert (ACT_TB) zu vergleichen. Der Sollwert wird dabei typischerweise von einer CPU vorgegeben. Dieser Teil generiert dann einen entsprechenden Trigger. Ein zweiter Teil kann über die Busschnittstelle beschrieben werden und einen Trigger auslösen (HOST_TRIG). Ein weiterer Teil kombiniert Trigger, die von Hardwareeinheiten (TOM) kommen können (Hardwaretrigger) und leitet daraus ein gemeinsames Triggersignal ab. Dieser Teil kann dabei die eingehenden Triggerleitungen flexibel miteinander kombinieren, so dass die topologische Lage, die die Hardwareeinheiten, die die Trigger auslösen, aufweisen, keine Rolle spielen. Die für den resultierenden Trigger gültigen Eingangstrigger werden in einem Register spezifiziert (INT_TRIG), das typischerweise von der CPU beschrieben wird.

Der Triggermechanismus weist darüber hinaus Ausgangsstrukturen auf, die den aus den Eingangstriggern resultierenden Gesamttrigger verarbeiten und entsprechende Ausgangstrigger und Aktionen in den angeschlossenen Hardwaremodulen (TOM) auslösen. Als Ausgangstriggermechanismus kann beispielsweise das Aus- oder Einschalten von mehreren Hardwareeinheiten parallel erfolgen (ENDIS_CTRL, ENDIS_STAT). Die Kontrolle, ob aus oder eingeschaltet wird, wird dabei mit einem Register 42 ENDIS_CTRL realisiert, wo diejenigen Hardwareeinheiten markiert werden, die beim Auftreten des Triggers gemeinsam ein- oder ausgeschaltet werden sollen. Der aktuelle Zustand, ob eine Einheit ein- oder ausgeschaltet ist, kann durch Lesen des Registers 52 ENDIS_STAT ermittelt werden. Darüber hinaus kann die CPU über das Businterface mehrere Kanäle direkt gleichzeitig ein- oder ausschalten, indem sie direkt auf das Register 52 ENDIS_STAT schreibt.

Ein weiterer Ausgangsmechanismus kann die Ausgangssignale der Hardwareeinheit (TOM) parallel zu oder abschalten. Hierbei ist es wiederum möglich, dies über den resultierenden Trigger (OUTEN_CTRL) oder von der CPU aus mit dem Register 50 OUTEN_STAT_zu regeln.

Noch ein weiterer Ausgangsmechanismus ist der gleichzeitig erzwungene Update von Parametern in den angeschlossenen Hardwareeinheiten (FUPD_CTRL). Dort wird in dem Register 38 eingetragen, an welchen der angeschlossenen Hardwareeinheiten die Parameter gleichzeitig aktualisiert werden sollen. Selbstverständlich können die Ausgangstriggermechanismen auch auf einzelne Hardwaremodule angewendet werden.

## Patentansprüche

1. Verfahren zum Ansteuern einer Anzahl an Modulen (100) mit einer Schaltungsanordnung (10), die einen flexiblen Triggermechanismus implementiert, bei dem mindestens ein Triggersignal von verschiedenen Quellen verursacht werden kann, **dadurch gekennzeichnet, dass** in Abhängigkeit der Quelle ein bestimmter Triggermechanismus ausgewählt wird, der einen Trigger auslöst.

2. Verfahren nach Anspruch 1, bei dem das Triggersignal durch mindestens eine eingegebene Zeitbasis (18, 20, 22) verursacht wird, die mit einem Sollwert verglichen wird, so dass der Trigger durch ein Zeitereignis ausgelöst wird.

3. Verfahren nach Anspruch 2, bei dem der Sollwert von einer zentralen Recheneinheit vorgegeben wird.

4. Verfahren nach einem der Ansprüche 1 bis 3, bei dem eine Busschnittstelle zur Eingabe eines Triggersignals verwendet wird, so dass der Trigger durch eine zentrale Recheneinheit ausgelöst wird.

5. Verfahren nach einem der Ansprüche 1 bis 4, bei dem das Triggersignal von einem angeschlossenen Modul (100) verursacht wird, so dass der Trigger durch ein Triggerereignis eines angeschlossenen Moduls (100) ausgelöst wird.

6. Schaltungsanordnung zur Ansteuerung einer Anzahl von Modulen (100), insbesondere zur Durchführung eines Verfahrens nach einem der Ansprüche 1 bis 5, mit einem logischen Gatter, das Signale von unterschiedlichen Quellen miteinander kombiniert und ein Triggersignal erzeugt.

7. Schaltungsanordnung nach Anspruch 6, bei der als logisches Gatter ein Oder-Gatter (36) dient

8. Schaltungsanordnung nach Anspruch 6 oder 7, bei der ein Multiplexer (16) zur Eingabe von mindestens einer Zeitbasis (18, 20, 22), ein Register (12) für einen Sollwert und ein Komparator (28) vorgesehen sind.

9. Schaltungsanordnung nach einem der Ansprüche 6 bis 8, bei der eine Busschnittstelle vorgesehen ist.

10. Schaltungsanordnung nach einem der Ansprüche 6 bis 9, bei der eine Schnittstelle (33) zur Anbindung von weiteren Modulen vorgesehen ist.

## Claims

1. Method for actuating a number of modules (100) with a circuit arrangement (10) which implements a flexible trigger mechanism, in which at least one trigger signal can be caused by different sources, **characterized in that** a particular trigger mechanism which initiates a trigger is selected on the basis of the source.

2. Method according to Claim 1, in which the trigger signal is caused by at least one input time base (18, 20, 22) which is compared with a desired value, with the result that the trigger is initiated by a time event.

3. Method according to Claim 2, in which the desired value is predefined by a central computing unit.

4. Method according to one of Claims 1 to 3, in which a bus interface is used to input a trigger signal, with the result that the trigger is initiated by a central computing unit.

5. Method according to one of Claims 1 to 4, in which the trigger signal is caused by a connected module (100), with the result that the trigger is initiated by a trigger event of a connected module (100).

6. Circuit arrangement for actuating a number of modules (100), in particular for carrying out a method according to one of Claims 1 to 5, having a logic gate which combines signals from different sources with one another and generates a trigger signal.

7. Circuit arrangement according to Claim 6, in which an OR gate (36) is used as the logic gate.

8. Circuit arrangement according to Claim 6 or 7, in which a multiplexer (16) for inputting at least one time base (18, 20, 22), a register (12) for a desired value and a comparator (28) are provided.

9. Circuit arrangement according to one of Claims 6 to 8, in which a bus interface is provided.

10. Circuit arrangement according to one of Claims 6 to 9, in which an interface (33) for connecting further modules is provided.

## Revendications

1. Procédé de commande de plusieurs modules (100) à l'aide d'un circuit (10) qui met en oeuvre un mécanisme flexible de déclenchement et dans lequel au moins un signal d'activation peut être produit par différentes sources,
**caractérisé en ce que**
un mécanisme défini de déclenchement qui déclenche une activation est sélectionné en fonction de la source.

2. Procédé selon la revendication 1, dans lequel le signal d'activation est provoqué par au moins une base temporelle (18, 20, 22) introduite qui est comparée avec une valeur de consigne de telle sorte que l'activation est déclenchée par un événement temporel.

3. Procédé selon la revendication 2, dans lequel la valeur de consigne est prédéterminée par une unité centrale de calcul.

4. Procédé selon l'une des revendications 1 à 3, dans lequel une interface de bus est utilisée pour introduire un signal d'activation de telle sorte que l'activation soit déclenchée par une unité centrale de calcul.

5. Procédé selon l'une des revendications 1 à 4, dans lequel le signal d'activation est provoqué par un module (100) raccordé, de telle sorte que l'activation soit déclenchée par un événement de déclenchement d'un module (100) raccordé.

6. Circuit de commande de plusieurs modules (100), en particulier pour la mise en oeuvre d'un procédé selon l'une des revendications 1 à 5, présentant une grille logique qui combine les uns avec les autres des signaux de différentes sources et qui forme un signal d'activation.

7. Circuit selon la revendication 6, dans lequel une grille OU (36) sert de grille logique.

8. Circuit selon les revendications 6 ou 7, présentant un multiplexeur (16) prévu pour introduire au moins une base temporelle (18, 20, 22), un registre (12) prévu pour une valeur de consigne et un comparateur (28).

9. Circuit selon l'une des revendications 6 à 8, dans lequel une interface de bus est prévue.

10. Circuit selon l'une des revendications 6 à 9, dans lequel une interface (33) est prévue pour le raccordement d'autres modules.
